# EUROPÄISCHE PATENTSCHRIFT

(11) **EP 1 036 488 B1**
(45) Veröffentlichungstag und Bekanntmachung des Hinweises auf die Patenterteilung: **27.03.2002**
(21) Anmeldenummer: 98965738.2
(22) Anmeldetag: 02.12.1998
(51) Int. Cl.: H05G 2/00, H01J 17/04, H01J 17/40, H05H 1/24

(54) **VORRICHTUNG UND VERFAHREN ZUR ERZEUGUNG VON EXTREM-ULTRAVIOLETTSTRAHLUNG UND WEICHER RÖNTGENSTRAHLUNG AUS EINER GASENTLADUNG**
METHOD AND DEVICE FOR PRODUCING EXTREME ULTRAVIOLET AND SOFT X-RAYS FROM A GASEOUS DISCHARGE
PROCEDE ET DISPOSITIF POUR PRODUIRE DES RAYONS ULTRAVIOLETS EXTREMES ET DES RAYONNEMENTS X MOUS A PARTIR D'UNE DECHARGE GAZEUSE

(30) Priorität: 03.12.1997 DE 19753696
(43) Veröffentlichungstag der Anmeldung: 20.09.2000
(73) Patentinhaber: FRAUNHOFER-GESELLSCHAFT ZUR FÖRDERUNG DER ANGEWANDTEN FORSCHUNG E.V., 80636 München (DE)
(72) Erfinder: NEFF, Willi, B-4721 Kelmis (BE); LEBERT, Rainer, B-4721 Kelmis (BE); SCHRIEVER, Guido, D-52066 Aachen (DE); BERGMANN, Klaus, D-52143 Herzogenrath (DE)
(86) Internationale Anmeldenummer: EP9807829
(87) Internationale Veröffentlichungsnummer: WO9929145

(56) Entgegenhaltungen:
- EP-A- 0 387 838
- DE-A- 3 942 307
- PATENT ABSTRACTS OF JAPAN vol. 013, no. 166 (E-746), 20. April 1989 & JP 64 000698 A (HITACHI LTD), 5. Januar 1989

## Beschreibung

### Technisches Gebiet

Die Erfindung betrifft eine Vorrichtung und ein Verfahren zur Erzeugung von Extrem-Ultraviolett- und Röntgenstrahlung wobei das die Strahlung emittierende Medium ein Plasma ist. Bevorzugtes Anwendungsgebiet sind Anwendungen, bei denen Röntgenlicht im Wellenlängenbereich um 10 nm erforderlich sind, wie es zum Beispiel bei der EUV-Projektionslithographie für den Spektralbereich um 13 nm der Fall ist, wo kompakte, preisgünstige und langlebige Röntgenlichtquellen erforderlich sind. Ein weiteres Anwendungsfeld sind Röntgenanalyseverfahren wie die Photoelektronenspektroskopie oder die Röntgenfluoreszenzanalyse, die den Spektralbereich der weichen Röntgenstrahlung nutzen, und welche mit der Verfügbarkeit einer kompakten Quelle im Labormaßstab realisiert werden können. Ferner können Verfahren und Vorrichtung zur Charakterisierung von Röntgenoptiken oder Röntgendetektoren eingesetzt werden.

### Stand der Technik

Der Einsatz eines Plasmas als Quelle für Röntgenlicht ist bekannt. Beispielsweise werden die Pfasmafokusentladung, die Z-Pinch-Entladung, die Kapillarentladung oder der Gas-Puff hierzu eingesetzt. So wird bei der Z-Pinch-Entladung zwischen zwei flächig ausgeführten Elektroden ein +Plasma erzeugt, wobei über die Wahl der Spannungspulse zwei Betriebsweisen zur Verfügung stehen. Zum einen ist ein Betrieb möglich, bei welcher die Gasentladung auf der Oberfläche des Isolators zündet. Dies führt zu einem erheblichen Verschleiß des Isolators. Zum anderen können die Strompulse auch so gewählt werden, daß die Gasentladung im ganzen zur Verfügung stehenden und durch den Isolator begrenzten Volumen zwischen Anode und Kathode zündet. Bei Beginn der Plasmazündung sind damit auch ein oder mehrere feine Plasmakanäle in der Nähe des Isolators und der Elektroden anzutreffen, wodurch diese einen Abbrand erfahren. Durch das Eigenmagnetfeld des dann fließenden Stromes kommt es zum Zusammenschnüren der Plasmakanäle zu einem einzigen Plasmakanal (Pinch-Effekt) entlang der Symmetrieachse der Elektrodenanordnung. Beim Erlöschen des Stromes breitet sich das Plasma wieder bis zum Isolator aus was ebenfalls mit einem Abbrand des Isolatormaterials verbunden ist. Ein weiterer Nachteil der Z-Pinch-Entladung ist ferner der Umstand, daß für die Bildung eines effektiv emittierenden Plasmas der Selbstdurchbruchbetrieb ungeeignet ist. Üblicherweise wird der Z-Pinch nur im Einzelpulsbetrieb eingesetzt, und dementsprechend ist die Ausbeute an Röntgenlicht gering. Stand der Technik für die Repetitionsrate, d.h die Rate für den Auf- und Abbau des röntgenlichtemittierenden Plasmas, sind typischerweise maximal 20 Pulse pro Sekunde. Wird der Gas-Puff zur Erzeugung eines röntgenlichtemittierenden Plasmas eingesetzt, so wird über eine geeignet positionierte Öffnung in Isolator oder Elektroden schubweise Gas in den Zwischenraum zwischen Anode und Kathode eingelassen. Der Plasmaaufbau erfolgt dann mit dem eingelassenen Gas zwischen den Elektroden. Gas-Puff, Z-Pinch und auch die Plasmafokusentladung werden zudem bei hohen Entladeströmen (> 100 kA) und im Bereich einiger Kilojoule für die elektrisch gespeicherte Energie betrieben. Sie sind daher für ein Plasma optimiert, welches Röntgenlicht im Spektralbereich einiger Nanometer (harte Röntgenstrahlung) emittiert.

Für langwelligere Strahlung im Bereich von ca. 10 nm bis ca. 50 nm werden Gasentladungen mit kleinen Strömen bzw. einer kleineren pro Puls umgesetzten Energie eingesetzt. Dabei kommt zum Beispiel die Kapillarentladung zum Einsatz, wobei sich die gleichen Nachteile hinsichtlich des Verschleißes wie oben beschrieb ergeben. Als eine Ausführungsvarianten sei hier eine Kapillarentladung genannt, bei der der Isolator zwingend für die Zündung des Plasmas gebraucht wird. Kennzeichnend bei diesem Entladungstyp ist das Verdampfen von Isolatormaterial welches nachfolgend in den Plasmazustand überführt wird. Der Abbrand des Isolators ist damit ebenfalls hoch. Alle genannten Entladungstypen werden dabei mit einem Arbeitspunkt auf dem rechten Ast der Paschenkurve betrieben, wobei durch den Pinch-Effekt gleichzeitig das Plasma aufgeheizt wird um die erforderliche Temperatur für die Röntgenlichtemission zu erreichen.

Nach dem Stand der Technik ist der Einsatz von Pseudofunkenschaltern bekannt, der zum Beispiel in der Ausführungsvariante als Mehrkanalpseudofunkenschalter in der DE 39 42 307 A1 offenbart ist. Diese zeichnen sich u.a. dadurch aus, daß das Plasma nicht in Kontakt mit Isolator oder Elektrodenfläche gezündet wird, und daß daher deren Lebensdauer hoch ist. Ebenfalls vorteilhaft ist deren hohe Repetitionsrate. Nachteilig bei diesen Schaltern ist jedoch, daß sie hinsichtlich der Gasart, des Gasdrucks und der Strompulse so betrieben werden, daß sich bei ihnen ein Plasma mit nur geringer Energiedichte ausbildet welches eine effektive Emission von EUV- oder Röntgenstrahlung ausschließt. Für die Emission von EUV- oder Röntgenstrahlung wäre daher eine Vorrichtung vorteilhaft, welche die Vorzüge von Z-Pinch-Entladung mit den Vorzügen des Pseudofunkenschalters kombiniert.

Aus der EP 0 387 838 ist ferner eine Vorrichtung zur Erzeugung einer Plasmaquelle bekannt welche im Röntgenbereich emittiert. Die Vorrichtung weist zwei zylinderförmige Elektroden mit gemeinsamer Symmetrieachse auf. Zwischen den Elektroden bildet sich ein Plasma aus, wobei sich das Plasma zum offenen Ende der Anordnung bewegt. Das Plasma erfährt am offenen Ende eine Kontraktion und emittiert Strahlung im Röntgenbereich.

Die JP 64 000698 A offenbart eine Plasmaröntgenquelle mit zwei Elektroden in einer Ausgestaltung zur Minimierung der Induktivität und Verbesserung von Wartungsarbeiten.

### Darstellung der Erfindung

Der Erfindung liegt die Aufgabe zugrunde, eine Vorrichtung und ein Verfahren für die Erzeugung von Röntgenstrahlung und/oder extremer Ultraviolett- (EUV-) Strahlung aus einer Gasentladung bereitzustellen, bei welchen der Isolator keinem Verschleiß ausgesetzt ist, und bei welchen Repetitionsraten bis in den Kilohertzbereich möglich sind, und bei denen bei Wahl geeigneter Parameter für Elektrodengeometrie, Gasdruck und -art sowie für die Strompulse ein Plasma mit hinreichend hoher Energiedichte bzw. Temperatur erzeugt wird, so daß es zu einer effektiven Emission von weicher Röntgenstrahlung kommt.

Die Lösung der vorrichtungsgemäßen Aufgabe wird durch die in Anspruch 1 gegebenen Merkmale gelöst, wobei vorteilhafte Ausgestaltungen in den Unteransprüchen 2 - 13 angegeben sind. Die verfahrensmäßige Aufgabe wird durch die Merkmale des Anspruchs 14 gelöst. Vorteilhafte Ausgestaltungen dieses Verfahrens werden in den Ansprüchen 15 - 25 angegeben.

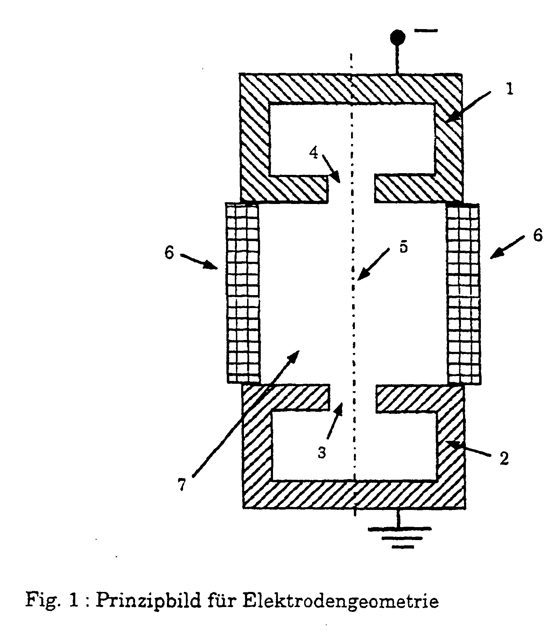

Erfindungsgemäß wurde erkannt, daß die o.g. Nachteile für gasentladungserzeugte Röntgenquellen vermieden werden können wenn über den Einsatz einer geeigneten Elektrodengeometrie sichergestellt wird, daß sich nur fern vom Isolator Plasma befindet. Dies ist möglich, wenn dem System unter Ausnutzung einer geeignet gewählten Elektrodengeometrie, wie zum Beispiel einer Hohlkathode mit einer Hohlanode, eine vorgebbare Vorzugsrichtung aufgeprägt wird. Diese Vorzugsrichtung stellt im Sinne des Hittorfschen Umwegeffekts sicher, daß sich die Gasentladung ausschließlich entlang dieser Vorzugsrichtung fern vom Isolator ausbildet. Eine Elektrodenkonfiguration, die diese Anforderungen erfüllt, ist zum Beispiel diejenige des Einkanalpseudofunkenschalters, welche in **Fig.1** dargestellt ist. Hierbei müssen die Elektroden so gestaltet sein, daß sich zwischen ihnen ein gasgefüllter Zwischenraum (7) befindet, jede Elektrode (1, 2) eine fluchtende Öffnung (3, 4) aufweist durch welche eine Symmetrieachse (5) definiert wird, und die Elektroden zylindersymmetrisch bzgl. obiger Symmetrieachse (5) sind. Die Symmetrieachse ist dann die oben genannte Vorzugsrichtung. Die Öffnungen der Elektroden haben dabei Durchmesser im Millimeterbereich. Zwischen den Elektroden befindet sich ein Isolator (6), welcher den Zwischenraum zwischen Anode und Kathode vom Außenbereich mit höherem Gasdruck trennt. Vorteilhaft ist es dabei, wenn der Isolator als Stapelung von Isolatoren und Metallscheiben ausgeführt ist, da dadurch die Spannungsfestigkeit verbessert wird. Der Elektrodenabstand liegt dabei im Millimeter- bis Zentimeterbereich. Der Gasdruck im Elektrodenzwischenraum liegt im Bereich von einigen Pascal bis einigen zehn Pascal. Der Arbeitspunkt wird dabei so gewählt, daß das Produkt aus Elektrodenabstand und Entladungsdruck auf dem linken Ast der Paschenkurve liegt. Die Zündspannung steigt in diesem Fall mit sinkendem Gasdruck bei fester Elektrodengeometrie. Allgemein hängt die Zündspannung von der Elektrodengeometrie, der Zahl der Elektroden (mindestens 2), dem Durchmesser der Öffnungen in den mindestens zwei Elektroden, und dem gewählten Arbeitsgasdruck ab. Nach Anlegen einer Spannung an die Elektroden, welche vorteilhafterweise im Bereich von einigen Kilovolt bis einigen zehn Kilovolt liegt, wird ein elektrisches Feld im Elektrodenzwischenraum aufgebaut, welches dort in guter Näherung parallel zur Symmetrieachse verläuft. Wenn die Elektroden als Hohlelektroden ausgestaltet sind, ragen die elektrischen Feldlinien im Bereich der Öffnungen auch in die Hohlelektroden hinein, und ganz allgemein in die an die Zwischenraumbewandungen angrenzenden Raumbereiche.

Bei genügend hohen Spannungen kommt es durch die bei Gasentladungen allgemein bekannten Mechanismen der Vervielfachung von Ladungsträgern zu einer Gasentladung. Die Zündung erfolgt dabei entweder im Selbstdurchbruchbetrieb über bereits vorhandene Ladungsträger die zum Beispiel über die kosmische Höhenstrahlung erzeugt werden können, oder aber bei getriggertem Betrieb durch Injektion von Ladungsträgern (Plasma oder Elektronen) in den an die Kathode angrenzenden Raumbereich. Durch die beschriebene Elektrodengeometrie kann sich die Gasentladung nicht auf dem kleinsten Weg zwischen den Elektroden ausbreiten, weil in diesem Fall die mittlere freie Weglänge der Ladungsträger größer als der Elektrodenabstand ist. Die Gasentladung sucht sich dann einen längeren Weg, da nur bei ausreichender Entladungsstrecke genügend viele ionisierende Stöße zur Aufrechterhaltung der Entladung möglich sind. Dieser längere Weg ist vorliegend durch die Öffnungen vorgebbar, über welche die Symmetrieachse definiert ist. Dies hat zur Folge, daß sich nur ein einziger Plasmakanal ausbildet, der die oben definierte Symmetrieachse (5) besitzt und dessen seitliche Ausdehnung durch die Öffnungen bestimmt wird. Sind die Öffnungen zum Beispiel konzentrisch geformte Bohrlöcher, so bildet sich das Plasma innerhalb des durch die Bohrlochbegrenzungen definierten Zylindervolumens aus. Dies wird auch durch Computersimulationen theoretisch vorhergesagt (J.B. Bouef, L.C. Pitchford, Pseudospark discharge via computer simulation, IEEE Trans. Plas. Sc., Vol. 19(2), 1991). Bei einer Gasentladung der dargestellten Geometrie auf dem linken Ast der Paschenkurve erfolgt der Aufbau des Plasmakanals nicht wie bei einer Streamerentladung über eine einzige kurzzeitige Elektronenlawine, sondern mehrstufig über Sekundärionisationsprozesse. Dadurch ist die Plasmaverteilung bereits in der Startphase in hohem Maße zylindersymmetrisch, ohne daß hierfür beispielsweise eine Isolatorwand erforderlich wäre. Dies hat zur Folge, daß auf zusätzliche Vorrichtungen zum Zünden des Plasmas bei der erfindungsgemäßen Vorrichtung verzichtet werden kann, da die Gasentladung im Selbstdurchbruch erfolgen kann. Mit einer zusätzlichen Zündvorrichtung kann aber erreicht werden, daß die Röntgenpulse zeitlich präzise ausgelöst werden, falls die Anwendung dies erfordert.

Bei Vorhandensein eines Plasmas kommt es zum Fließen eines gepulsten Stromes, wobei der Strom von einer geeigneten Stromquelle zur Verfügung gestellt werden muß. Durch eine geeignete Wahl von Amplitude und Periodendauer der Strompulse kann die für die Röntgenlichtemission geeignete Temperatur des Plasmas eingestellt werden, welche typischerweise im fünfstelligen Kelvinbereich liegt. Das Gas oder Gasgemisch ist so zu wählen, daß es im Plasmazustand charakteristische Strahlung im weichen Röntgenwellenlängenbereich emittiert, was bei Gasen insbesondere für Kernladungszahlen Z ≥ 3 der Fall ist. Die verwendeten Strompulse weisen vorteilhafterweise Amplituden mit zweistelliger Kiloamperezahl und Periodendauern im zwei- bis dreistelligem Nanosekundenbereich auf. Insbesondere bei diesen Parametern für die Strompulse wird das Plasma im Elektrodenzwischenraum entlang der Symmetrieachse hinreichend komprimiert und dadurch aufgeheizt, daß es für die erforderliche Temperatur für die Röntgenlichtemission erreicht.

Das Zurverfügungstellen der Strompulse erfolgt dabei durch eine Integration der Elektrodenkonfiguration in einen elektrischen Entladekreis, welcher vorteilhafterweise eine Kondensatorbank mit kapazitiv gespeicherter Energie aufweist. Dabei kann das Elektrodensystem entweder direkt mit der Kondensatorbank verbunden sein oder sich ein Schaltelement zwischen Elektrodensystem und Kondensatorbank befinden. Die direkte elektrische Verbindung eignet sich zum Beispiel beim Gasentladungsbetrieb im Selbstdurchbruch bei dem bei Erreichen der Zündfeldstärke die Gasentladung selbstätig zündet. Der Einsatz eines Schaltelements zwischen Elektrodensystem und Kondensatorbank erlaubt es, eine Spannung an das Elektrodensystem anzulegen welche größer als die erforderliche Zündspannung ist. Da die Zündspannung bei gewählen Arbeitspunkt auf dem linken Ast der Paschenkurve mit sinkendem Gasdruck steigt, bedeutet dies, daß man dann bei höheren Gasdrücken arbeiten kann. Dies führt wunschgemäß zu einer höheren Intensität der emittierten Strahlung, da die Intensität quadratisch mit dem Gasdruck skaliert. Auch können Repetitionsraten bis in den Kilohertzbereich erreicht werden, was für viele Anwendungen einen Vorteil gegenüber dem Einzelschußbetrieb bedeutet.

Werden die für den Betrieb der Röntgenquelle erforderlichen Strompulse von einer Kondensatorbank zur Verfügung gestellt, so bildet diese zusammen mit dem Elektrodensystem einen gedämpften elektrischen Schwingkreis, dessen Schwingungsverhalten durch seine Kenngrößen Kapazität, Induktivität und ohmscher Widerstand bestimmt ist. Die oben angegebenen Werte für die Stromamplituden beziehen sich in einem solchen Fall auf die erste Halbwelle des in seiner Stärke oszillierenden und gleichzeitig abnehmenden Stromes.

Ohne Einschränkung des allgemeinen Erfindungsgedankens sollen die erfindungsgemäße Vorrichtung an einem Ausführungsbeispiel erläutert werden.

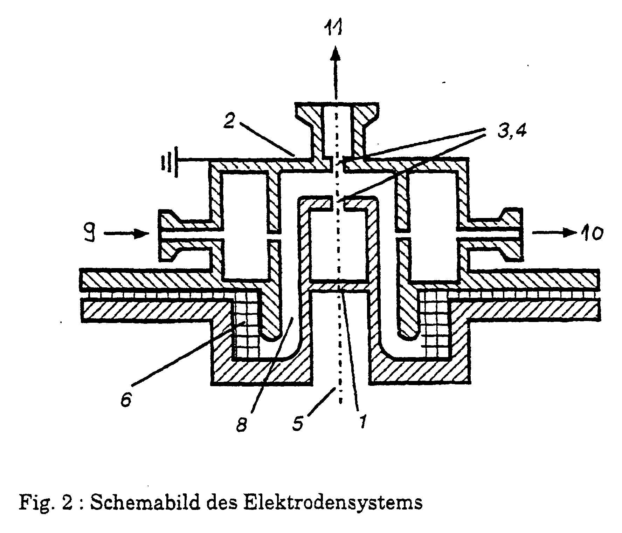

**Fig. 2** zeigt eine Elektrodengeometrie mit der wie beschrieben ohne Isolatorverschleiß Röntgenlicht aus einer Gasentladung heraus generiert werden kann. Der Abstand der rund ausgeführten Öffnungen (3, 4) beträgt 6 mm bei einem Durchmesser von 5 mm. Vom Gaseinlaß (9) her strömt stationär Sauerstoff Richtung Pumpe (10). Es wurde festgestellt, daß bei dieser zylindersymmetrischen Anordnung trotz des prinzipiell vorhandenen Druckgradienten die Druckunterschiede im Bereich der Öffnungen (3, 4) vernachlässigbar ist, und die Zündung des Plasmas nur in dem Volumen erfolgt, welches durch die Öffnungen von Anode und Kathode vorgegeben ist. Der stationäre Gasfluß sichert im vorliegenden Fall einen weitgend räumlich homogenen Gasdruck. Es kann jedoch auch mit einem größeren Druckgradienten gearbeitet werden so daß zwischen Gaseinlaß (9) und Pumpe (10) ein Druckgefälle herrscht. Das Druckmeßgerät integriert Meßwerte über einen Zeitraum von 5 Sekunden und liefert einen Wert von 10 Pa. Der Arbeitspunkt ist dabei so gewählt, daß das Produkt aus Elektrodenabstand und Entladungsdruck auf dem linken Ast der Paschenkurve liegt. Das aufwendig gestaltete Elektrodensystem ist wie in der Zeichnung zu erkennen direkt mit einem Plattenkondensator verbunden. Der Plasmakanal bildet sich bei diesem Ausführungsbeispiel ausschließlich im durch und zwischen den Öffnungen (3, 4) definierten Kanal entlang der Symmetrieachse (5) aus. In anderen Raumbereichen zwischen Anode (2) und Kathode (1), zum Beispiel im Bereich (8), kann sich kein Plasmakanal ausbilden, da dort der für eine Zündung der Gasentladung erforderliche lange Weg nicht vorliegt. Dies hat zur Folge, daß der Isolator (6) keinen Abbrand erfährt. Bei einer Ladespannung von 6 kV zwischen Anode (2) und Kathode (1) betrug die Stromamplitude der ersten Halbwelle im hier praktizierten Selbstdurchbruchbetrieb ca. 15 kA bei einer Schwingungsdauer von 730 ns. Die emittierte Strahlung wird von einem Detektor (11) nachgewiesen.

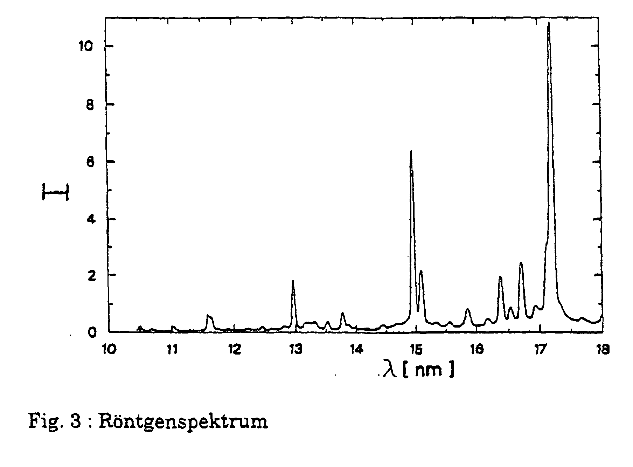

**Fig. 3** zeigt ein mit einem Gitterspektrographen aufgenommenes Röntgenspektrum bei einer verwendeten Ladespannung von 6 kV. Bei diesem ist die detektierte Intensität **I** in willkürlichen Einheiten gegenüber der Wellenlänge λ in Nanometern abgetragen. Es treten charakteristische Übergänge von Sauerstoffionen auf, die im Plasmazustand nur noch 3 bis 4 Elektronen besitzen. Dies läßt auf eine Plasmatemperatur von ca. 20 bis 40 eV schließen.

## Patentansprüche

1. Vorrichtung zur Erzeugung von Extrem-Ultraviolett- und/oder weicher Röntgenstrahlung aus einer Gasentladung mit mindestens zwei Elektroden (1, 2), nämlich einer Anode (2) und einer Kathode (1), zwischen denen ein Zwischenraum (7) mit einer weitgehend räumlich homogenen Gasfüllung vorgesehen ist, in dem sich ein Plasma ausbilden kann **dadurch gekennzeichnet,**
- **daß** die Elektroden (1, 2) je eine fluchtende Öffnung (3, 4) aufweisen, durch welche eine Symmetrieachse (5) definiert ist,
- **daß** die Elektroden (1, 2) so geformt sind, daß sich die Gasentladung auschließlich in dem durch die fluchtenden Öffnungen (3, 4) bestimmten Volumen ausbildet,
- und **daß** die Strompulse hinsichtlich Amplitude und Periodendauer derart gewählt sind, daß ein dichter heißer Plasmakanal auf der Symmetrieachse (5) entsteht, welcher Plasma-Quelle für Extrem-Ultraviolett und/oder weiche Röntgenstrahlung ist.

2. Vorrichtung nach Anspruch 1, **dadurch gekennzeichnet, daß** die Strompulse eine Periodendauer im zwei- bis dreistelligen Nanosekundenbereich besitzen.

3. Vorrichtung nach einem der Ansprüche 1 - 2, **dadurch gekennzeichnet, daß** die Strompulse Amplituden im zweistelligen Kiloamperebereich aufweisen.

4. Vorrichtung nach einem der Ansprüche 1 - 3, **dadurch gekennzeichnet, daß** das Plasma eine Temperatur im sechsstelligem Kelvinbereich besitzt

5. Vorrichtung nach einem der Ansprüche 1 - 4, **dadurch gekennzeichnet, daß** das Plasma Quelle für Strahlung mit einer Wellenlänge kleiner 50 nm ist.

6. Vorrichtung nach einem der Ansprüche 1 - 5, **dadurch gekennzeichnet, daß** der Durchmesser der Öffnungen (3, 4) im Millimeterbereich liegt.

7. Vorrichtung nach einem der Ansprüche 1 - 6, **dadurch gekennzeichnet, daß** die Plasmazündung durch Injektion von Plasma oder Ladungsträgern in dem an die Kathode (1) angrenzenden Raumbereich erfolgt.

8. Vorrichtung nach einem der Ansprüche 1 - 7, **dadurch gekennzeichnet, daß** der Abstand der Elektroden (3, 4) im Millimeter- bis Zentimeterbereich liegt.

9. Vorrichtung nach einem der Ansprüche 1 - 8, **dadurch gekennzeichnet, daß** der Isolator zwischen Anode (2) und Kathode (1) als Stapel von Isolatoren und Metallscheiben ausgestaltet ist.

10. Vorrichtung nach einem der Ansprüche 1 - 9, **dadurch gekennzeichnet, daß** die Strompulse von einer sich schnell entladenden Kondensatorbank zur Verfügung gestellt werden.

11. Vorrichtung nach Anspruch 10, **dadurch gekennzeichnet, daß** das Elektrodensystem direkt mit einer Kondensatorbank verbunden ist.

12. Vorrichtung nach Anspruch 10, **dadurch gekennzeichnet, daß** sich zwischen Elektrodensystem und Kondensatorbank ein Schaltelement befindet.

13. Vorrichtung nach einem der Ansprüche 1 - 12, **dadurch gekennzeichnet, daß** sich zwischen den Elektroden (3, 4) ein oder mehrere Gase mit einer Kernladungszahl Z ≥ 3 befinden.

14. Verfahren zur Erzeugung von Extrem-Ultraviolett- und/oder weicher Röntgenstrahlung aus einer Gasentladung, bei dem man in einem Zwischenraum (7), der sich zwischen mindestens zwei Elektroden (1, 2) befindet, eine weitgehend räumlich homogene Gasfüllung bereitstellt, und bei dem man die Strompulse hinsichtlich Amplitude und Periodendauer derart wählt, daß das entstehende Plasma Quelle für die Emission von Extrem-Ultraviolett und/oder weichem Röntgenlicht wird,
**dadurch gekennzeichnet,**
- **daß** man den Gasdruck so wählt, daß nach Anlegen einer Spannung an die mit fluchtenden Öffnungen (3, 4) versehenen Elektroden (1, 2) die mittlere freie Weglänge der Ladungsträger auschließlich in dem durch die fluchtenden Öffnungen (3, 4) bestimmten Volumen ausreicht um dort ein Plasma auszubilden,
- und **daß** nachfolgend ein dichter heißer Plasmakanal auf der durch die fluchtenen Öffnungen (3, 4) definierten Symmetrieachse (5) vorliegt, welcher die Extrem-Ultraviolett und/oder Röntgenstrahlung emittiert.

15. Verfahren nach Anspruch 14, **dadurch gekennzeichnet, daß** Strompulse mit einer Periodendauer im zwei- bis dreistelligen Nanosekundenbereich gewählt werden.

16. Verfahren nach einem der Ansprüche 14 - 15, **dadurch gekennzeichnet, daß** Strompulse mit Amplituden im zweistelligen Kiloamperebereich gewählt werden.

17. Verfahren nach einem der Ansprüche 14 - 16, **dadurch gekennzeichnet, daß** das Plasma eine Temperatur im sechsstelligem Kelvinbereich besitzt

18. Verfahren nach einem der Ansprüche 14 - 17, **dadurch gekennzeichnet, daß** Gasdrücke im Bereich 1 Pa bis einigen 10 Pa gewählt werden.

19. Verfahren nach einem der Ansprüche 14 - 18, **dadurch gekennzeichnet, daß** das Plasma Strahlung mit Wellenlängen kleiner 50 nm emittiert.

20. Verfahren nach einem der Ansprüche 14 - 19, **dadurch gekennzeichnet, daß** als Gase im Zwischenraum (7) solche mit einer Kernladungszahl Z ≥ 3 gewählt werden.

21. Verfahren nach einem der Ansprüche 14 - 20, **dadurch gekennzeichnet, daß** das Plasma durch Injektion von Plasma oder Ladungsträgern in dem an die Kathode (1) angrenzenden Raumbereich gezündet wird.

22. Verfahren nach einem der Ansprüche 14 - 21, **dadurch gekennzeichnet, daß** der bei Vorhandensein eines Plasmas fließende Strom durch die schnelle Entladung kapazitiv gespeicherter Energie bereitgestellt wird.

23. Verfahren nach Anspruch 22, **dadurch gekennzeichnet, daß** die schnelle Entladung dadurch erreicht wird, daß das Elektrodensystem direkt mit einer Kondensatorbank verbunden wird.

24. Verfahren nach Anspruch 22, **dadurch gekennzeichnet, daß** die schnelle Entladung dadurch erreicht wird, daß ein zwischen Elektrodensystem und Kondensatorbank befindliches Schaltelement geschlossen wird.

25. Verfahren nach Anspruch 24, **dadurch gekennzeichnet, daß** an die Elektroden eine Spannung angelegt wird welche größer als die Zündspannung der Gasentladung ist.

## Claims

1. Device for producing extreme ultraviolet and/or soft X-ray radiation from a gas discharge with at least two electrodes (1, 2), namely an anode (2) and a cathode (1), between which an intermediate space (7) with an extensively spatially homogenous gas filling is provided, in which intermediate space a plasma is formed,
**characterised in that**
· the electrodes (1, 2) each have a flush opening (3, 4) by means of which an axis of symmetry (5) is defined,
· **in that** the electrodes (1, 2) are formed in such a manner that the gas discharge is formed exclusively in the volume determined by the flush openings (3, 4),
· and **in that** the current pulses with respect to amplitude and period duration are chosen in such a manner that a dense hot plasma channel is produced on the axis of symmetry (5), which channel is the plasma source for extreme ultraviolet and/or soft X-ray radiation.

2. Device according to claim 1, **characterised in that** the current pulses have a period duration in the two to three digit nanosecond range.

3. Device according to one of the claims 1 - 2, **characterised in that** the current pulses have amplitudes in the two digit kiloampere range.

4. Device according to one of the claims 1 - 3, **characterised in that** the plasma has a temperature in the six digit Kelvin range.

5. Device according to one of the claims 1 - 4, **characterised in that** the plasma is the source for radiation with a wavelength smaller than 50 nm.

6. Device according to one of the claims 1 - 5, **characterised in that** the diameter of the openings (3, 4) lies in the millimetre range.

7. Device according to one of the claims 1 - 6, **characterised in that** the plasma ignition is effected by injection of plasma or charge carriers in the spatial region abutting against the cathode (1).

8. Device according to one of the claims 1 - 7, **characterised in that** the spacing of the electrodes (3, 4) lies in the millimetre to centimetre range.

9. Device according to one of the claims 1 - 8, **characterised in that** the insulator between the anode (2) and cathode (1) is configured as a stack of insulators and metal discs.

10. Device according to one of the claims 1 - 9, **characterised in that** the current pulses are made available from a fast-discharging capacitor bank.

11. Device according to claim 10, **characterised in that** the electrode system is connected directly to a capacitor bank.

12. Device according to claim 10, **characterised in that** a switch element is located between the electrode system and the capacitor bank.

13. Device according to one of the claims 1 - 12, **characterised in that** one or more gases with an atomic number Z≥ 3 is located between the electrodes (3, 4).

14. Method for producing extreme ultraviolet and/or soft X-ray radiation from a gas discharge in which an extensively spatially homogenous gas filling is provided in an intermediate space (7), which is located between at least two electrodes (1, 2) and in which the current pulses are chosen with respect to amplitude and period duration in such a manner that the resultant plasma becomes the source for the emission of extreme ultraviolet and/or soft X-ray light,
**characterised in that,**
· the gas pressure is chosen such that, after applying a voltage to the electrodes (1, 2) which are provided with flush openings (3, 4), the average free path length of the load carriers is sufficient, exclusively in the volume determined by the flush openings (3, 4), in order to form a plasma there,
· and **in that** subsequently a dense hot plasma channel is present on the axis of symmetry (5), which is defined by the flush openings (3, 4), which channel emits the extreme ultraviolet and/or X-ray radiation.

15. Method according to claim 14, **characterised in that** the current pulses are chosen with a period duration in the two to three digit nanosecond range.

16. Method according to one of the claims 14 - 15, **characterised in that** the current pulses are chosen with amplitudes in the two digit kiloampere range.

17. Method according to one of the claims 14 - 16, **characterised in that** the plasma has a temperature in the six digit Kelvin range.

18. Method according to one of the claims 14 - 17, **characterised in that** gas pressures are chosen in the range 1 Pa to several 10 Pa.

19. Method according to one of the claims 14 - 18, **characterised in that** the plasma emits radiation with wavelengths smaller than 50 nm.

20. Method according to one of the claims 14 - 19, **characterised in that** those gases which have an atomic number Z≥ 3 are chosen as the gases in the intermediate space (7).

21. Method according to one of the claims 14 - 20, **characterised in that** the plasma is ignited by injection of plasma or load carriers in the spatial region abutting against the cathode (1).

22. Method according to one of the claims 14 - 21, **characterised in that** the current flowing in the presence of a plasma is provided by the fast discharge of capacitively-stored energy.

23. Method according to claim 22, **characterised in that** the fast discharge is achieved **in that** the electrode system is connected directly to a capacitor bank.

24. Method according to claim 22, **characterised in that** the fast discharge is achieved **in that** a switch element is connected which is located between the electrode system and the capacitor bank.

25. Method according to claim 24, **characterised in that** a voltage is applied to the electrodes which is greater than the ignition voltage of the gas discharge.

## Revendications

1. Dispositif pour générer un rayonnement ultraviolet extrême et/ou des rayons X mous à partir d'une décharge de gaz à l'aide d'au moins deux électrodes (1, 2) à savoir une anode (2) et une cathode (1) entre lesquelles on a un espace intermédiaire (7) avec un remplissage de gaz très largement homogène dans l'espace,
dans lequel se développe un plasma,
**caractérisé en ce que**
- les électrodes (1, 2) ont une ouverture alignée (3, 4) qui définit un axe de symétrie (5),
- les électrodes (1, 2) sont formées pour que la décharge de gaz se développe exclusivement dans le volume défini par les ouvertures alignées (3, 4), et
- l'impulsion de courant est choisie en amplitude et en durée pour arriver à un canal de plasma chaud, dense suivant l'axe de symétrie (5), et qui constitue une source de plasma pour un rayonnement ultraviolet extrême et/ou un rayonnement de rayons X mous.

2. Dispositif selon la revendication 1,
**caractérisé en ce que**
les impulsions de courant ont une durée de période de la plage des nanosecondes à deux ou trois chiffres.

3. Dispositif selon l'une des revendications 1 et 2,
**caractérisé en ce que**
la source de courant a une amplitude dans la plage des kilo ampères à deux chiffres.

4. Dispositif selon l'une des revendications 1 à 3,
**caractérisé en ce que**
le plasma a une température qui dans le domaine des degrés Kelvin correspond à un nombre à six chiffres.

5. Dispositif selon l'une des revendications 1 à 4,
**caractérisé en ce que**
le plasma est une source de rayonnement pour une longueur d'onde de 50 nm.

6. Dispositif selon l'une des revendications 1 à 5,
**caractérisé en ce que**
le diamètre des orifices (3, 4) est du domaine millimétrique.

7. Dispositif selon l'une des revendications 1 à 6,
**caractérisé en ce que**
l'allumage du plasma se fait par injection de plasma ou par des porteurs de charge dans la plage de l'espace adjacente à celui de la cathode (1).

8. Dispositif selon l'une des revendications 1 à 7,
**caractérisé en ce que**
la distance des électrodes (3, 4) est de l'ordre du millimètre-centimètre.

9. Dispositif selon l'une des revendications 1 à 8,
**caractérisé en ce que**
l'isolateur entre l'anode (2) et la cathode (1) est formé par une pile d'isolateurs et de disques métalliques.

10. Dispositif selon l'une des revendications 1 à 9,
**caractérisé en ce que**
les impulsions de courant sont fournies par un ensemble de condensateur à décharge rapide.

11. Dispositif selon la revendication 10,
**caractérisé en ce que**
le système d'électrode est relié directement à un ensemble de condensateurs.

12. Dispositif selon la revendication 10,
**caractérisé par**
un élément de commutation entre le système d'électrode et l'ensemble de condensateur.

13. Dispositif selon l'une des revendications 1 à 12,
**caractérisé par**
un ou plusieurs gaz ayant un nombre de charge de noyau Z ≥ 3 entre les différentes électrodes (3, 4).

14. Procédé pour produire une lumière ultraviolette extrême et/ou un rayonnement X mou à partir d'une décharge de gaz,
selon lequel
dans l'intervalle (7) entre au moins deux électrodes (1, 2) on fournit une charge de gaz essentiellement homogène dans l'espace et pour laquelle on détermine les impulsions de courant en amplitude et en durée de période de façon que le plasma engendré constitue une source pour l'émission de lumière ultraviolette extrême et/ou de rayons X mous,
**caractérisé en qu'**
- on choisit la pression du gaz pour qu'après application d'une tension aux électrodes (1, 2) munies d'orifices alignés (3, 4), la longueur d'onde libre moyenne des porteurs de charge est définie exclusivement par le volume défini par les orifices alignés (3, 4) pour y former le plasma,
- ensuite on a un canal de plasma chaud, dense ayant un axe de symétrie (5) défini par les orifices alignés (3, 4) et émettant le rayonnement ultraviolet dur et/ou le rayonnement de rayons X mous.

15. Procédé selon la revendication 14,
**caractérisé en ce qu'**
on choisit des impulsions de courant d'une durée de période dans la plage des nanosecondes avec des nombres à deux ou trois chiffres.

16. Procédé selon les revendications 14 à 15,
**caractérisé en ce qu'**
on choisit des impulsions de courant avec des amplitudes de la plage du kilo ampères à deux chiffres.

17. Procédé selon les revendications 14 à 16,
**caractérisé en ce que**
le plasma est à une température située dans le domaine Kelvin pour une température à six chiffres.

18. Procédé selon les revendications 14 à 17,
**caractérisé en ce que**
les pressions de gaz se situent dans une plage comprise entre 1 Pa et quelques 10 Pa.

19. Procédé selon les revendications 14 à 18,
**caractérisé en ce que**
le plasma émet un rayonnement avec une longueur d'onde inférieure à 50 nm.

20. Procédé selon les revendications 14 à 19,
**caractérisé en ce qu'**
on choisit comme gaz dans le volume intérieur (7), les gaz ayant un nombre de charges de noyaux Z ≥ 3.

21. Procédé selon les revendications 14 à 20,
**caractérisé en ce qu'**
on allume le plasma par injection de plasma ou de porteur de charge dans la plage d'espace adjacente à la cathode (1).

22. Procédé selon les revendications 14 à 21,
**caractérisé en ce qu'**
en cas de présence d'un courant traversant le plasma, on fournit un accumulateur d'énergie capacitif pour la décharge rapide.

23. Procédé selon la revendication 22,
**caractérisé en ce que**
la décharge rapide s'obtient en reliant le système d'électrodes directement à un ensemble de condensateurs.

24. Procédé selon la revendication 22,
**caractérisé en ce que**
la décharge rapide s'obtient **en ce qu'**entre le système d'électrodes et l'ensemble des condensateurs on a branché un élément de commutation.

25. Procédé selon la revendication 24,
**caractérisé en ce que**
on applique une tension aux électrodes qui est supérieure à la tension d'allumage de la décharge de gaz.
